(19) Europäisches Patentamt / European Patent Office / Office européen des brevets

(11) **EP 4 617 686 A1**

(12) **DEMANDE DE BREVET EUROPEEN**

(43) Date de publication:
**17.09.2025 Bulletin 2025/38**

(21) Numéro de dépôt: **25163629.6**

(22) Date de dépôt: **13.03.2025**

(51) Classification Internationale des Brevets (IPC):
**G01R 23/167** *(2006.01)* **H03H 17/02** *(2006.01)*
**H03H 17/06** *(2006.01)*

(52) Classification Coopérative des Brevets (CPC):
**H03H 17/0223; H03H 17/0233; H03H 17/06;**
G01R 23/167

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**GE KH MA MD TN**

(30) Priorité: **14.03.2024 FR 2402558**

(71) Demandeur: **THALES
92190 Meudon (FR)**

(72) Inventeurs:
• **DERVIN, Patrick
33700 MERIGNAC (FR)**
• **ROBERT, François
33700 MERIGNAC (FR)**
• **CAUDOUX, Frédéric
33700 MERIGNAC (FR)**
• **BOUYAT, Stéphane
33700 MERIGNAC (FR)**

(74) Mandataire: **Lavoix
2, place d'Estienne d'Orves
75441 Paris Cedex 09 (FR)**

(54) **PROCÉDÉ DE FILTRAGE NUMÉRIQUE À RÉPONSE IMPULSIONNELLE FINIE ET DISPOSITIF DE FILTRAGE ASSOCIÉ**

(57) La présente invention concerne un procédé de filtrage à réponse impulsionnelle finie, comprenant les étapes suivantes :
- acquisition (110) d'un signal numérique correspondant à un signal analogique converti par un convertisseur analogique/numérique ;
- application (120) d'un traitement numérique au signal numérique pour transformer ce signal en une somme d'une partie variable en temps et d'une partie constante dans le temps ;
- élimination (130) de la partie variable du signal numérique transformé pour obtenir un signal numérique constant, par application d'un enchaînement d'une pluralité de filtres coupe-bandes sinusoïdaux ;
- traitement numérique (140) du signal numérique constant pour obtenir une amplitude de ce signal ;
- transmission (150) de ladite amplitude à un logiciel applicatif.

FIG.3

**EP 4 617 686 A1**

**Description**

La présente invention concerne un procédé de filtrage numérique à réponse impulsionnelle finie. La présente invention concerne également un dispositif de filtrage associé à un tel procédé.

Dans l'avionique, il est nécessaire d'utiliser des capteurs pour estimer des valeurs tele que la position pour assurer la sécurité des systèmes.

Les signaux utiles acquis par des capteurs pour les systèmes avioniques sont convertis sous forme numérique afin d'en permettre le traitement informatique.

Souvent, il est nécessaire de capter non seulement le contenu utile de ces signaux numériques mais aussi d'en éliminer les composantes dites alternatives, qui varient dans le temps. Ces composantes peuvent aussi bien provenir de bruits captés que de traitements appliqués à ces signaux.

Pour supprimer les composantes indésirables, différentes méthodes de filtrage des plages de fréquence problématiques sont généralement employées.

Ces méthodes de filtrage de l'état de la technique utilisent des filtres numériques parmi deux grandes classes : les filtres à réponse impulsionnelle finie (FIR, de l'anglais «Finite Impulse Response» ) et les filtres à réponse impulsionnelle infinie (IIR , de l'anglais «Infinite Impulse Response» ). Les deux types cités ont leurs avantages et leurs inconvénients mais les deux s'utilisent largement dans le domaine avionique.

Les filtres de type IIR sont des filtres qui demandent peu de coefficients de calcul et d'opérations mais ne possèdent pas, de la part de leur structure, de recouvrement rapide après une perturbation et ont souvent une latence élevée.

Les filtres de type FIR sont les plus souvent utilisés pour plusieurs raisons, parmi lesquelles on peut citer leur côté déterministe et robuste, en plus de leur capacité de recouvrement suite à une perturbation tout en gardant une latence faible.

Cependant, il est connu que les filtres de type FIR nécessitent beaucoup de ressources de calcul et présentent un coût économique élevé.

Il existe donc un besoin pour un filtrage numérique à réponse impulsionnelle finie qui soit moins onéreux et demandant en ressources de calcul que les technologies actuelles.

A cet effet, la présente description a pour objet un procédé de filtrage numérique à réponse impulsionnelle finie, comprenant les étapes suivantes :

- acquisition d'un signal numérique correspondant à un signal analogique converti par un convertisseur analogique/-numérique ;
- application d'un traitement numérique au signal numérique pour transformer ce signal en une somme d'une partie variable en temps et d'une partie constante dans le temps ;
- élimination de la partie variable du signal numérique transformé pour obtenir un signal numérique constant, par application d'un enchaînement d'une pluralité de filtres coupe-bandes sinusoïdaux ;
- traitement numérique du signal numérique constant pour obtenir une amplitude de ce signal ;
- transmission de ladite amplitude à un logiciel applicatif.

Suivant d'autres aspects avantageux de l'invention, le procédé comprend une ou plusieurs des caractéristiques suivantes prise(s) isolément ou suivant toutes les combinaisons possibles :

- la pluralité de filtres coupe-bandes sinusoïdaux comprend entre 2 et 20 filtres coupe-bandes sinusoïdaux, avantageusement entre 4 et 10 filtres coupe-bandes sinusoïdaux ;
- le nombre de filtres coupe-bandes dans la pluralité de filtres coupe-bandes sinusoïdaux est choisi en fonction d'une plage de fréquences du signal numérique ;
- chaque filtre coupe-bandes sinusoïdal présente une pluralité de paramètres de configuration permettant de le configurer ; avantageusement, chaque filtre coupe-bandes sinusoïdal présente deux paramètres de configuration ;
- chaque filtre coupe-bandes sinusoïdal présente au moins un premier paramètre de configuration correspondant à une fréquence de coupure principale et un deuxième paramètre de configuration correspondant à un écartement du filtre ;
- les filtres coupe-bandes sinusoïdaux de ladite pluralité de filtres coupe-bandes sinusoïdaux présentent des paramètres de configuration différents ;
- les paramètres de configuration des différents filtres coupe-bandes sinusoïdaux sont choisis de sorte que les fréquences de coupures des uns correspondent sensiblement aux fréquences passantes des autres ;
- l'étape d'élimination comprend en outre une application d'une ou de plusieurs moyennes glissantes au signal numérique issu de l'enchaînement de la pluralité de filtres coupe-bandes sinusoïdaux ;
- le signal analogique est issu d'un capteur avionique et dans lequel le logiciel applicatif est un logiciel avionique ;

- l'étape de traitement numérique comprend en outre la détermination d'une phase du signal constant.

L'invention a également pour objet un dispositif de filtrage à réponse impulsionnelle finie, comprenant des moyens techniques configurés pour mettre en œuvre le procédé tel que décrit précédemment.

L'invention apparaitra plus clairement à la lecture de la description qui va suivre, donnée uniquement à titre d'exemple non limitatif et faite en référence aux dessins dans lesquels :

- [Fig.1] la figure 1 est une vue d'une architecture d'acquisition de signaux analogiques comprenant un dispositif de filtrage selon l'invention ;
- [Fig. 2] la figure 2 est une vue détaillée du dispositif de filtrage de la figure 1 ;
- [Fig. 3] la figure 3 est un organigramme d'un procédé de filtrage selon l'invention, le procédé étant mis en œuvre par le dispositif de la figure 2 ; et
- [Fig 4] [Fig 5] [Fig 6] [Fig 7] [Fig 8] [Fig 9] [Fig 10] les figures 4 à 10 sont différentes illustrations de la mise en œuvre d'au moins certaines des étapes du procédé de la figure 3,

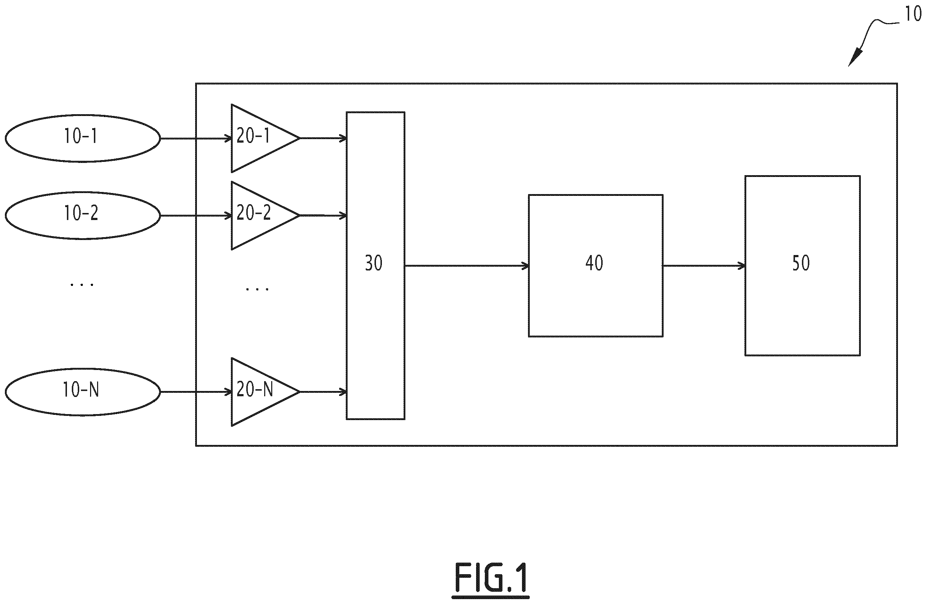

La figure 1 illustre une architecture d'acquisition 10 de signaux analogiques, utilisable par exemple dans le domaine avionique. Cette architecture 10 permet de convertir des signaux analogiques en signaux numériques et de transmettre ces derniers à une ou plusieurs applications avioniques.

Selon d'autres modes de réalisation, l'architecture d'acquisition 10 est utilisable dans tout autre domaine mettant en œuvre une conversion de signaux analogiques en signaux numériques.

En référence à la figure 1, l'architecture d'acquisition 10 comprend un ensemble de capteurs 10-1,...,10-N, un ensemble de conditionneurs de signaux 20-1,...,20-N, un convertisseur analogique-numérique 30, un dispositif de filtrage 40 et un ou plusieurs logiciels 50.

Les capteurs 10-1,...,10-N sont au nombre N (N>0) et sont par exemple des capteurs avioniques de la même nature ou de natures différentes. Chaque capteur 10-1,...,10-N est configuré plus particulièrement pour mesurer au moins une grandeur physique ou pour recevoir des signaux externes, et pour générer, à de cette mesure ou de signaux externes, des signaux analogiques. Ainsi, chaque capteur 10-1,...,10-N correspond par exemple à un capteur de position, de pression, de vitesse, de température, ou par exemple à un capteur de signaux GNSS (de l'anglais « Global Navigation Satellite Systems ») ou de tout autre signal relatif à la position de l'aéronef. Lorsqu'il s'agit d'un capteur de position, celui-ci peut correspondre à un capteur électromagnétique, par exemple un capteur linéaire de type LVDT (de l'anglais « Linear Variable Differential Transformer »), un capteur rotatif de type RVDT (de l'anglais « Rotary Variable Differential Transformer »), un capteur rotatif résolveur ou encore, un capteur rotatif de type SYNCHRO.

Avantageusement, chaque capteur 10-1,...,10-N est disposé à l'extérieur de l'aéronef, par exemple sur le fuselage de celui-ci.

Les conditionneurs de signaux 20-1,...,20-N, dont le nombre dépend du nombre de capteurs 10-1,...,10-N, sont connectés à ces derniers et permettent par exemple d'amplifier et/ou de mettre en forme les signaux analogiques acquis par ces capteurs 10-1,...,10-N. Avantageusement, les conditionneurs 20-1,...,20-N sont au nombre N, tout comme les capteurs 10-1,...,10-N. Ainsi, chaque conditionneur 20-1,...,20-N est raccordé à un capteur respectif 10-1,...,10-N.

Le convertisseur analogique-numérique 30 est connecté à l'ensemble des conditionneurs de signaux 20-1,...,20-N et permet de convertir les signaux analogiques issus des conditionneurs 20-1,...,20-N en signaux numériques. Un tel convertisseur 30 est connu par exemple sous l'abréviation « ADC » (de l'anglais « Analog to digital Converter »).

Le ou chaque logiciel 50 présente par exemple une application avionique connectée au dispositif de filtrage 40. Un tel logiciel 50 est configuré pour recevoir des signaux numériques issus de ce dispositif de filtrage 40 et pour les traiter en fonction de la nature du capteur 10-1,...,10-N correspondant à ces signaux. Par exemple, un tel logiciel 50 est configuré pour déduire la position de l'aéronef à partir des signaux acquis lorsque ces signaux correspondent aux signaux GNSS et/ou sont issus d'un ou plusieurs capteurs de position, pour afficher et/ou communiquer à tout système intéressé cette position et/ou la vitesse de l'aéronef.

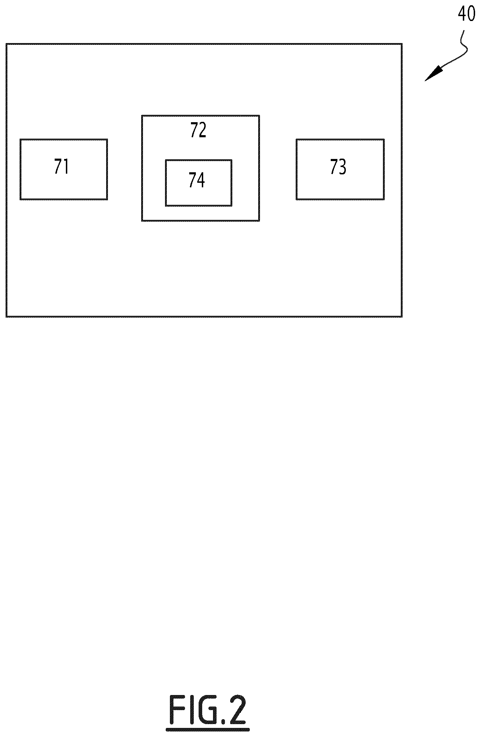

Le dispositif de filtrage 40 est illustré plus en détail sur la figure 2. Ce dispositif de filtrage 40 est par exemple mis en œuvre au moins partiellement sous la forme d'un ou de plusieurs circuits logiques programmable tels que FPGA (de l'anglais « Field Programmable Gate Array »). En complément ou en variante, ce dispositif de filtrage 40 est mis en œuvre au moins partiellement sous la forme d'un et de plusieurs logiciels. Dans ce cas, ces logiciels sont stockés dans une mémoire adaptée et sont exécutables par un ou plusieurs processeurs.

En référence à la figure 2, le dispositif de filtrage 40 comprend un module d'entrée 71, un module de traitement 72 et un module de sortie 73.

Le module d'entrée 71 permet de recevoir les signaux numériques convertis par le convertisseur analogique-numérique 30.

Le module de traitement 72 permet de traiter les signaux numériques convertis afin d'éliminer leur partie variable dans le temps. En particulier, pour ce faire, le module de traitement 72 comprend une unité de filtrage passe-bas 74 configurée pour appliquer un filtre coupe-bande sinusoïdal, comme cela sera expliqué plus en détail par la suite.

Enfin, le module de sortie 73 permet de transmettre les signaux traités par le module de traitement 72 à un ou plusieurs logiciel 50.

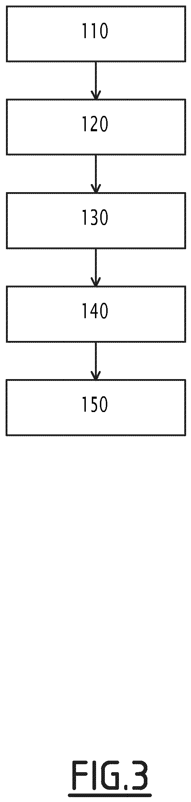

Le dispositif de filtrage 40 permet de mettre œuvre un procédé de filtrage qui sera désormais expliquer en référence à la figure 3 présentant un organigramme de ses étapes.

Il est initialement considéré que les capteurs 10-1,...,10-N sont en fonctionnement et acquièrent des mesures/signaux correspondant(e)s sous la forme des signaux analogiques. Il est considéré en outre que ces signaux analogiques présentent une forme sinusoïdale et contiennent une information utile dans l'amplitude de cette forme sinusoïdale et éventuellement dans sa phase. En particulier, il est considéré que chaque signal acquis $f(t)$ présente une forme suivante :

$$f(t) = A * \sin(2\pi Ft + \varphi)$$

où

A désigne l'amplitude du signal et correspond donc à l'information utile de celui-ci ;
F désigne la fréquence du signal ;
$\varphi$ désigne la phase à l'origine du signal.

Les conditionneurs 20-1,...,20-N mettent en forme et amplifient éventuellement les signaux analogiques correspondants et les transmettent au convertisseur analogique-numérique 30. Ce convertisseur 30 convertit alors ces signaux analogiques en signaux numériques correspondants.

Lors d'une étape initiale 110, le module d'entrée 71 acquiert les signaux numériques convertis par le convertisseur analogique-numérique 30.

Lors d'une étape 120 suivante, le module de traitement 72 applique un traitement numérique à chaque signal numérique acquis par le module d'entrée 71 pour transformer ce signal en une somme d'une partie variable en temps et d'une partie constante dans le temps.

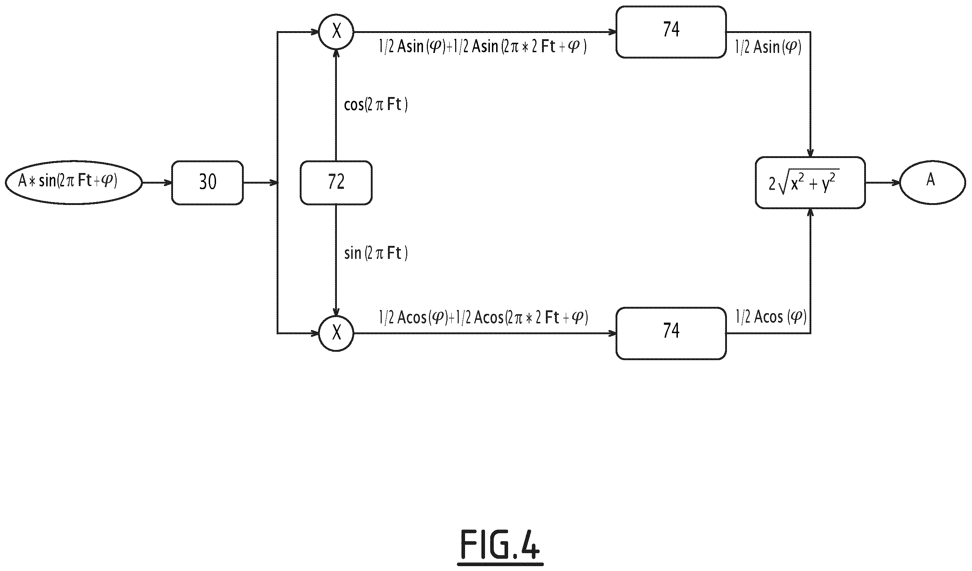

Un exemple de la mise en œuvre de l'étape 120 est illustré sur la figure 4. Selon cet exemple, le module de traitement 72 met en œuvre une technique connue sous l'appellation de « démodulation synchrone ».

Conformément à cette technique, le module de traitement 72 divise le signal numérique acquis en deux signaux identiques et multiplie chaque signal obtenu par une fonction sinusoïdale ayant la même partie temporelle que le signal numérique acquis.

En particulier, comme le montre la figure 4, le module de traitement 72 divise le signal acquis $f(t) = A * \sin(2\pi Ft + \varphi)$ en deux parties identiques et multiplie chacune de ces parties respectivement par $\sin(2\pi Ft)$ et $\cos(2\pi Ft)$ pour obtenir deux signaux intermédiaires suivants :

$$Y(t) = f(t) * \cos(2\pi Ft) = \frac{1}{2} * A * \sin(\varphi) + \frac{1}{2} * A * \sin(2 * 2\pi Ft + \varphi);$$

$$X(t) = f(t) * \sin(2\pi Ft) = \frac{1}{2} * A * \cos(\varphi) + \frac{1}{2} * A * \cos(2 * 2\pi Ft + \varphi).$$

Chaque signal intermédiaire présente ainsi une somme d'une partie variable en temps et d'une partie constante dans le temps.

Lors d'une étape 130 suivante, l'unité de filtrage passe-bas 74 applique un filtrage à chaque signal intermédiaire dans le but d'éliminer sa partie variable dans le temps.

En effet, en dénotant par $H(f)$ la fonction de filtrage appliquée par l'unité de filtrage 74, l'unité de filtrage passe-bas 74 obtient à la sortie les signaux intermédiaires filtrés :

$$s(A, \varphi) = Y(f) * H(f) = \frac{1}{2} * A * \sin(\varphi);$$

$$c(A, \varphi) = X(f) * H(f) = \frac{1}{2} * A * \cos(\varphi);$$

qui sont constants dans le temps et ne dépendent plus de la fréquence *F*.

Lors d'une étape 140 suivante, le module de traitement 72 élimine la phase $\varphi$ de chaque signal filtré pour ne garder que son amplitude *A*.

Comme cela est montré sur la figure 4, pour ce faire, le module de traitement 72 peut additionner les carrés des signaux intermédiaires filtrés de sorte que :

$$A = 2\sqrt{s(A,\varphi)^2 + c(A,\varphi)^2}.$$

Optionnellement, lors de cette étape, le module de traitement 72 calcule également la phase $\varphi$.

Lors d'une étape 150 suivante, le module de sortie 73 transmet l'amplitude *A* et éventuellement la phase $\varphi$ à un ou plusieurs logiciels avioniques 50.

Selon l'invention, pour éliminer la partie variable dans le temps lors de l'étape 130, l'unité de filtrage passe-bas 74 applique un filtrage de type FIR (de l'anglais «Finite Impulse Response») qui présente un enchaînement d'une pluralité de filtres coupe-bandes sinusoïdaux.

Par « enchaînement d'une pluralité de filtre », on entend une application enchaînée de ces filtres de sorte que chaque filtre suivant (sauf le premier filtre) est appliqué à la sortie du filtre précédent. Le premier filtre est appliqué à la fonction initiale.

Par « filtre coupe-bandes sinusoïdal » appelé également filtre CBS, on entend un filtre numérique de type FIR dont la courbe du gain en fonction de la fréquence est une fonction sinusoïdale de la fréquence.

Plus particulièrement, le cas d'un filtre coupe-bandes sinusoïdal, sa courbe du gain G(f) est une fonction sinusoïdale de la fréquence.

La réponse *y(n)* d'un tel filtre s'écrit sous la forme suivante :

$$y(n) = KG * (x(n - 2e) + KFC * x(n - e) + x(n))$$

avec :

$$KFC = -\cos\left(\frac{2\pi F_c}{F_s} * e\right);$$

$$KG = \frac{1}{1 + KFC + 1}$$

où :

- $F_c$ est la fréquence de coupure principale ;
- $F_s$ est la fréquence d'échantillonnage du signal ;
- *e* est l'écartement du filtre ; et
- *x* (*n*) sont différents échantillon du signal d'entrée.

La fréquence d'échantillonnage $F_S$ est imposée lors de l'acquisition.

Comme indiqué ci-dessus, les coefficients *KFC* et *KG* sont déductibles directement des valeurs $F_c$, $F_S$ et *e*.

La fréquence de coupure principale $F_c$ et l'écartement du filtre e sont deux paramètres distincts de chaque filtre coupe-bandes sinusoïdal. Ces paramètres forment donc des paramètres de configuration de chaque filtre.

Chaque filtre CBS présente avantageusement plusieurs fréquences de coupure, c'est-à-dire plusieurs fréquences dans lesquelles la fonction du gain de ce filtre est égale à 0.

Par ailleurs, chaque filtre CBS présente plusieurs fréquences passantes, c'est-à-dire plusieurs fréquences dans lesquelles la fonction du gain de ce filtre est égale à 1.

Selon l'invention, les paramètres $F_c$ et e sont choisis pour chaque filtre CBS dans l'enchaînement des filtres CBS en fonction des fréquences de coupure et passantes souhaitées pour ce filtre CBS.

En particulier, les paramètres $F_c$ et e sont choisis pour les filtres CBS de sorte que les fréquences de coupures des uns correspondent aux fréquences passantes des autres. Cette correspondance peut être exacte ou approximative.

Pour ce faire, par exemple, il peut être considéré que l'enchaînement des filtres CBS comprend un premier sous-ensemble de filtres CBS et un deuxième sous-ensemble de filtres CBS.

Dans un tel cas, les paramètres $F_c$ et *e* du premier sous-ensemble des filtres peuvent être choisis de sorte à définir une pluralité de fréquences de coupure prédéterminées et les paramètres $F_c$ et *e* du deuxième sous-ensemble peuvent être choisis de sorte à définir une pluralité de fréquences de coupure correspondant aux fréquences passantes des filtres CBS du premier sous-ensemble.

Autrement dit, les paramètres $F_c$ et $e$ du premier sous-ensemble des filtres sont choisis pour créer des fréquences de coupures bien déterminées, et les paramètres $F_c$ et $e$ du deuxième sous-ensemble sont choisis pour éliminer ce que le premier sous-ensemble des filtres laisse passer, de sorte à créer un filtrage global passe bas en plus des coupures franches.

De manière analogue, les paramètres $F_c$ et $e$ du deuxième sous-ensemble des filtres CBS peuvent être choisis de sorte à définir une pluralité de fréquences de coupure prédéterminées et les paramètres $F_c$ et e du premier sous-ensemble des filtres CBS peuvent être choisis de sorte à définir une pluralité de fréquences passantes correspondant aux fréquences de coupure des filtres CBS du deuxième sous-ensemble.

Bien entendu, d'autres techniques de choix des paramètres $F_c$ et e peuvent encore être utilisées dans le but d'obtenir une réponse résultante quasi nulle sauf en 0. Ceci réalise alors un filtre passe-bas en plus des coupures franches.

Avantageusement, le nombre des filtres CBS dans l'enchaînement des filtres est supérieur ou égal à 2. Ce nombre peut par exemple être compris entre 2 et 15, de préférence entre 2 et 10 et peut être égal dans certains exemples à 2, 3, 4, 5, 6 ou 7.

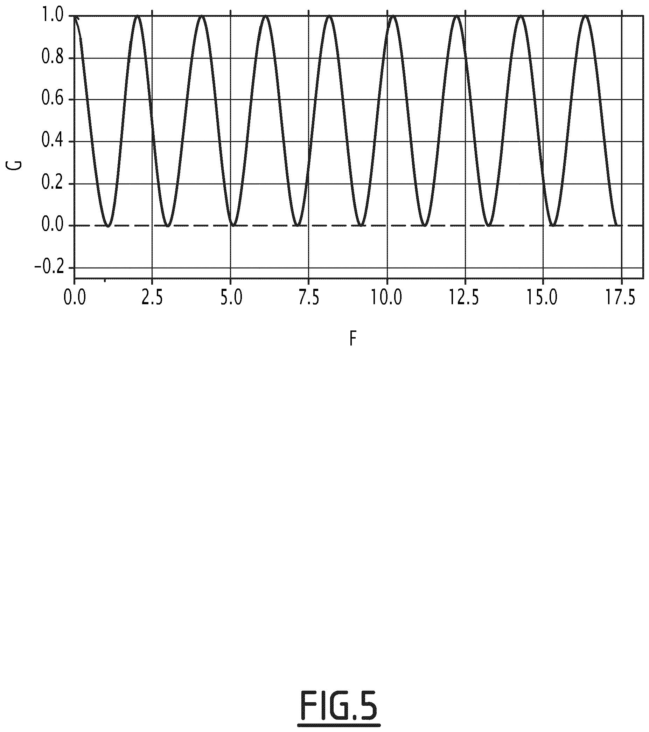

Les figures 5 à 10 illustrent un exemple d'application d'un enchaînement des filtres CBS avec différents nombres de filtres.

En particulier, la figure 5 illustre la sortie du premier filtre CBS dans l'enchainement des filtres CBS. Cette sortie présente une fonction sinusoïdale avec plusieurs fréquences de coupures et plusieurs fréquences passantes.

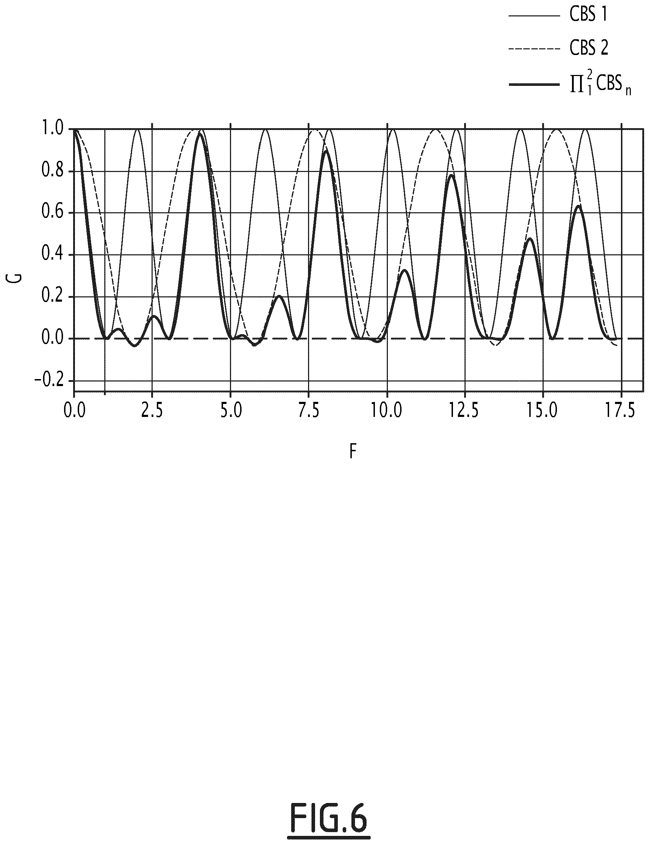

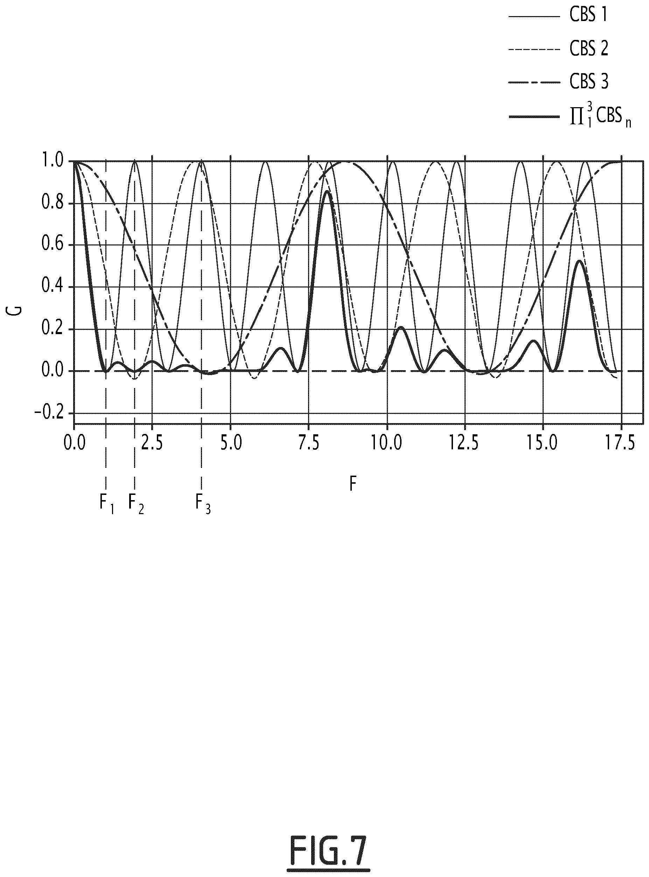

Les figures 6 et 7 illustrent des réponses individuelles respectivement de deux filtres CBS (CBS 1, CBS 2) et de trois filtres CBS (CBS 1, CBS 2, CBS 3). Ces figures illustrent également la fonction résultante Π CBS correspondant au produit de ces réponses individuelles (i.e. fonction résultante après l'enchaînement de deux ou de trois filtres CBS).

Comme cela est visible sur la figure 7, la fonction résultante des trois filtres CBS (CBS 1, CBS 2, CBS 3) crée au moins trois coupures franches, notamment dans les points $F_1$, $F_2$ et $F_3$

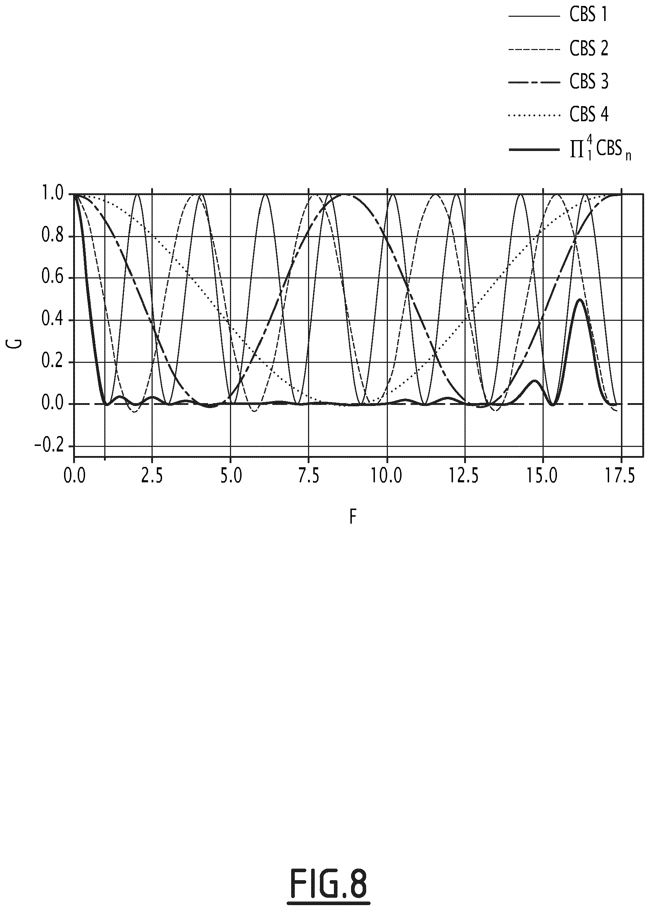

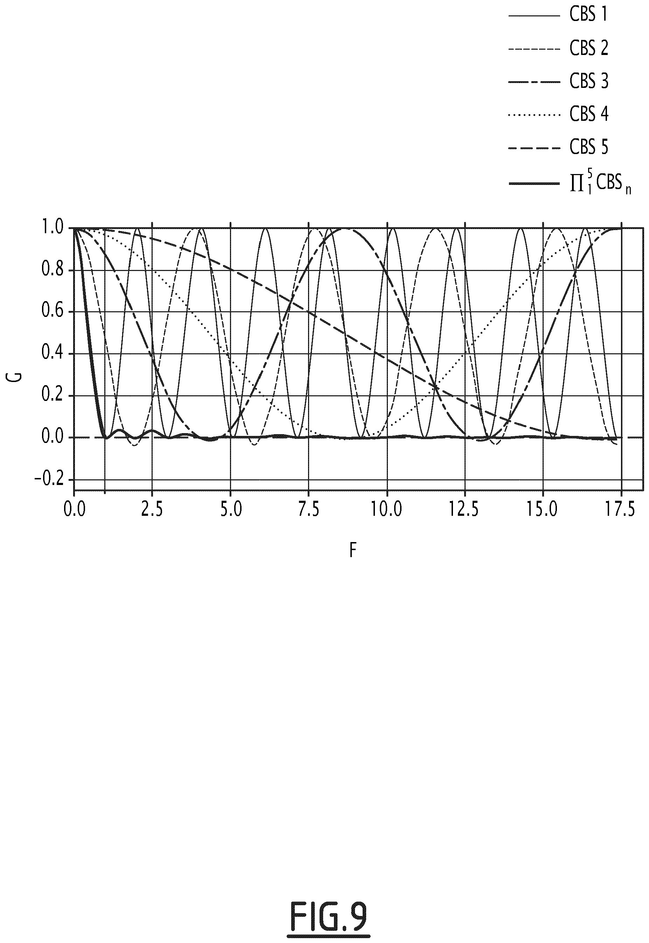

Les figures 8 et 9 illustrent en outre des réponses individuelles respectivement d'un filtre CBS (CBS 4) et de deux filtres CBS (CBS 4, CBS 5).

Selon les explications données ci-dessus, les filtres CBS 1, CBS 2, CBS 3 peuvent former un premier sous-ensemble des filtres et les filtres CBS 4, CBS 5 peuvent former un deuxième sous-ensemble des filtres.

Ainsi, comme le montrent les figures 8 et 9, les fréquences de coupure du deuxième sous-ensemble sont placées sur les fréquences passantes qui restent en sortie de la fonction résultante des filtres du premier sous-ensemble. Ceci met plus en avant l'avantage du procédé, qui permet d'avoir plusieurs coupures franches n'importe où, en plus de la fonction passe bas final.

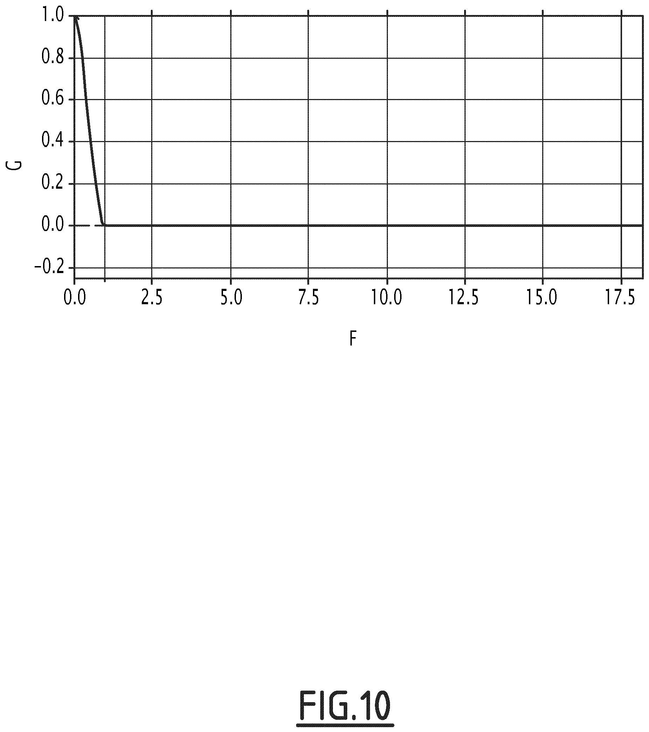

Enfin, la figure 10 illustre une fonction résultante après une application de sept filtres CBS. Comme cela est visible sur cette figure, cette fonction vaut presque partout 0 sauf aux environs de 0 où elle vaut 1.

De manière générale, le nombre de filtres CBS dans l'enchaînement des filtres CBS est déterminé en fonction de la plage de fréquence d'acquisition nécessaire.

Dans un mode de réalisation, l'enchaînement des filtres CBS est suivi d'une application d'une moyenne glissante pour permettre un lissage du résultat final et une réponse plus proche d'une gaussienne. Cet ajout permet de lisser le résultat tout en évitant un nombre de filtres CBS trop élevé. Dans l'exemple précédent avec l'enchaînement de sept filtres CBS, l'application d'une moyenne glissante peut par exemple remplacer l'application de deux et trois derniers filtres CBS.

On conçoit alors que la présente invention présente un certain nombre d'avantages.

Tout d'abord, l'invention permet de filtrer des signaux numériques à l'aide d'une multitude de filtres CBS dont les ressources en calcul nécessaires au fonctionnement de ces derniers sont faibles en comparaison d'un filtrage FIR classique.

En particulier, la solution proposée consiste à aligner en série ces filtres CBS et éventuellement ajouter une moyenne glissante pour avoir un résultat le plus proche possible d'une gaussienne à coupure franche.

Grâce à l'invention, il est possible de filtrer des signaux en garantissant des résultats précis et de façon peu onéreuse et économique en ressources de calcul.

De plus, l'invention permet de filtrer des signaux de façon robuste aux perturbations et aux incertitudes.

Par ailleurs, l'invention garantit des résultats rapides avec une cadence plus élevée qu'un filtre FIR classique.

Le traitement d'un échantillon du signal demande peu d'opérations, donc même avec un nombre réduit de coefficients, on peut traiter un grand nombre de points dans un délai court. Au contraire, un filtre FIR classique de mêmes caractéristiques demanderai beaucoup plus d'opérations, et pour aller aussi vite il faudrait avoir beaucoup plus de coefficients.

**Revendications**

1. Procédé de filtrage à réponse impulsionnelle finie, comprenant les étapes suivantes :

   - acquisition (110) d'un signal numérique correspondant à un signal analogique converti par un convertisseur analogique/numérique (30) ;
   - application (120) d'un traitement numérique au signal numérique pour transformer ce signal en une somme d'une partie variable en temps et d'une partie constante dans le temps ;
   - élimination (130) de la partie variable du signal numérique transformé pour obtenir un signal numérique constant, par application d'un enchaînement d'une pluralité de filtres coupe-bandes sinusoïdaux ;
   - traitement numérique (140) du signal numérique constant pour obtenir une amplitude de ce signal ;
   - transmission (150) de ladite amplitude à un logiciel applicatif (50).

2. Procédé selon la revendication 1, dans lequel la pluralité de filtres coupe-bandes sinusoïdaux comprend entre 2 et 20 filtres coupe-bandes sinusoïdaux, avantageusement entre 4 et 10 filtres coupe-bandes sinusoïdaux.

3. Procédé selon la revendication 1 ou 2, dans lequel le nombre de filtres coupe-bandes dans la pluralité de filtres coupe-bandes sinusoïdaux est choisi en fonction d'une plage de fréquences du signal numérique.

4. Procédé selon l'une quelconque des revendications précédentes, dans lequel chaque filtre coupe-bandes sinusoïdal présente une pluralité de paramètres de configuration permettant de le configurer ;
   avantageusement, chaque filtre coupe-bandes sinusoïdal présente deux paramètres de configuration.

5. Procédé selon la revendication 4, dans lequel chaque filtre coupe-bandes sinusoïdal présente au moins un premier paramètre de configuration correspondant à une fréquence de coupure principale et un deuxième paramètre de configuration correspondant à un écartement du filtre.

6. Procédé selon la revendication 4 ou 5, dans lequel les filtres coupe-bandes sinusoïdaux de ladite pluralité de filtres coupe-bandes sinusoïdaux présentent des paramètres de configuration différents.

7. Procédé selon l'une quelconque des revendications 4 à 6, dans lequel les paramètres de configuration des différents filtres coupe-bandes sinusoïdaux sont choisis de sorte que les fréquences de coupures des uns correspondent sensiblement aux fréquences passantes des autres.

8. Procédé selon l'une quelconque des revendications précédentes, dans lequel l'étape d'élimination (130) comprend en outre une application d'une ou de plusieurs moyennes glissantes au signal numérique issu de l'enchaînement de la pluralité de filtres coupe-bandes sinusoïdaux.

9. Procédé selon l'une quelconque des revendications précédentes, dans lequel le signal analogique est issu d'un capteur avionique (10-1, ..., 10-N) et dans lequel le logiciel applicatif (50) est un logiciel avionique.

10. Procédé selon l'une quelconque des revendications précédentes, dans lequel l'étape de traitement numérique (150) comprend en outre la détermination d'une phase du signal constant.

11. Dispositif de filtrage (40) à réponse impulsionnelle finie, comprenant des moyens techniques configurés pour mettre en œuvre le procédé selon l'une quelconque des revendications précédentes.

<u>FIG.1</u>

40

71

72

74

73

FIG.2

FIG.3

FIG.4

FIG.5

FIG.6

FIG.7

## FIG.8

FIG.9

FIG.10

# EP 4 617 686 A1

**RAPPORT DE RECHERCHE EUROPEENNE**

Europäisches Patentamt
European Patent Office
Office européen des brevets

Numéro de la demande

EP 25 16 3629

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | SEROV ANDREY N ET AL: "Application of the Method based on Averaging of the Squares of Samples for the RMS Measurement of Polyharmonic Signals", 2020 XXX INTERNATIONAL SCIENTIFIC SYMPOSIUM 'METROLOGY AND METROLOGY ASSURANCE (MMA), IEEE, 7 septembre 2020 (2020-09-07), pages 1-7, XP033859825, DOI: 10.1109/MMA49863.2020.9254239 * page 340 - page 343; figures 1-3 * * page 345, alinéa VI * ----- | 1-11 | INV. G01R23/167 H03H17/02 H03H17/06 |
| X | SEROV ANDREY N ET AL: "Method of Reducing of the Complex Spectrum Measurement Error In Case of Applying of the Quadrature Demodulation Technique", 2021 21ST INTERNATIONAL SYMPOSIUM ON POWER ELECTRONICS (EE), IEEE, 27 octobre 2021 (2021-10-27), pages 1-6, XP034040566, DOI: 10.1109/EE53374.2021.9628242 * page 2 - page 3; figure 1 * ----- | 1-5,8-11 | |

DOMAINES TECHNIQUES RECHERCHES (IPC)

H03H
G01R

Le présent rapport a été établi pour toutes les revendications

| Lieu de la recherche | Date d'achèvement de la recherche | Examinateur |
|---|---|---|
| Munich | 28 juillet 2025 | Mesplede, Delphine |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

................................................................

& : membre de la même famille, document correspondant

EPO FORM 1503 03.82 (P04C02)

18